(19) Europäisches Patentamt
European Patent Office
Office européen des brevets

(11) **EP 2 976 819 B1**

(12) **FASCICULE DE BREVET EUROPEEN**

(45) Date de publication et mention
de la délivrance du brevet:
**02.09.2020 Bulletin 2020/36**

(21) Numéro de dépôt: **14711492.0**

(22) Date de dépôt: **18.03.2014**

(51) Int Cl.:
*H02H 1/00* *(2006.01)*          *H02H 3/04* *(2006.01)*
*H02H 3/17* *(2006.01)*          *G01R 31/11* *(2006.01)*

(86) Numéro de dépôt international:
**PCT/EP2014/055379**

(87) Numéro de publication internationale:
**WO 2014/147056 (25.09.2014 Gazette 2014/39)**

(54) **DISPOSITIF DE PROTECTION DE RESEAUX ELECTRIQUES**

VORRICHTUNG ZUM SCHUTZ VON STROMNETZEN

DEVICE FOR PROTECTING POWER GRIDS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **18.03.2013 FR 1352376**

(43) Date de publication de la demande:
**27.01.2016 Bulletin 2016/04**

(73) Titulaire: **WIN MS
91400 Orsay (FR)**

(72) Inventeurs:
 • **OLIVAS, Marc
   F-91120 Palaiseau (FR)**
 • **PELTIER, Arnaud
   F-91400 Gometz La Ville (FR)**

(74) Mandataire: **Lucas, Laurent Jacques et al
Marks & Clerk France
Conseils en Propriété Industrielle
Immeuble Visium
22, Avenue Aristide Briand
94117 Arcueil Cedex (FR)**

(56) Documents cités:
**EP-A1- 2 221 626     US-A- 2 602 841
US-A- 4 109 117     US-A- 5 381 348**

**Description**

La présente invention a pour objet un dispositif de protection des réseaux électriques. Elle s'applique pour la protection de tous types de réseaux électriques indépendamment de leur nature, qu'ils soient destinés à l'alimentation électrique ou au transfert de données.

La protection des installations électriques, de toutes natures, est fondamentale pour la sécurité des personnes et des biens. En effet, un défaut électrique provoque fréquemment un incendie aux conséquences souvent désastreuses. Un défaut électrique peut aussi provoquer une électrification de zones sensibles ou, de façon plus dramatique, l'électrocution de personnes.

La protection électrique s'applique à tous les types d'installations électriques. On peut notamment citer la protection électrique des bâtiments, des sites industriels, des aéronefs et des automobiles par exemple. On peut encore citer la protection électrique sur les infrastructures nouvelles de production électrique telles que les éoliennes ou les champs de panneaux photovoltaïques notamment. D'autres infrastructures nécessitent également d'être protégées électriquement, par exemple les bornes de rechargement de véhicules électriques.

Dans de nombreux cas, les effets produits par les défauts électriques sont aggravés par le manque de réactivité des organes de coupure de l'alimentation électrique. En effet, lorsque des défauts électriques surviennent, il existe encore de nombreuses situations dans lesquelles l'organe de coupure de l'alimentation électrique est activé trop tardivement. Le temps de détection d'un défaut est un paramètre très important dans la chaîne de protection. Plus le temps de réaction à l'apparition d'un défaut électrique est court, plus les chances d'annuler son effet, ou au moins de le limiter, sont grandes.

Des solutions sont connues pour sécuriser les installations électriques. Ces solutions sont basées essentiellement sur l'analyse de grandeurs électriques comme le couple courant/tension. Elles présentent plusieurs inconvénients, ces inconvénients étant fonction du type d'application.

Un premier inconvénient est le manque de réactivité. Les dispositifs actuels présentent un compromis entre la qualité de la détection et le taux de fausse alarme, certains équipements de protection pouvant laisser passer une quinzaine d'arcs électriques avant de prendre la décision d'ouvrir le circuit. Beaucoup de systèmes actuels présentent donc des temps de réponse trop longs. En particulier, le temps de diagnostic est rallongé par le fait d'avoir des défauts intermittents de type arcs séries ou parallèles car il faut plusieurs itérations avant de prendre la décision de mettre une ligne en sécurité.

Pour certaines applications, les réseaux électriques présentent d'autres contraintes, c'est le cas notamment des réseaux de câbles dans les avions. Un réseau avionique nécessite un système de protection redondant, de faible encombrement et de faible masse, avec une fiabilité maximum. Des solutions existent pour l'aéronautique mais le fait de rendre un avion de plus en plus électrique et la contrainte d'une solution de protection par ligne, et donc par charge, ont pour conséquence des cœurs électriques de plus en plus imposants et donc de plus en plus lourds, notamment à cause des capteurs de courant. Ces solutions ne sont donc pas entièrement satisfaisantes.

Les réseaux câblés à l'intérieur des véhicules automobiles ont d'autres exigences en ce qui concerne leur protection. Actuellement, les systèmes de protection dans les véhicules automobiles se limitent à des fusibles. Une nouvelle contrainte dans ce domaine est notamment due à l'apparition de packs de batteries très sensibles aux courts-circuits avec un risque d'explosion. Les niveaux de tension ont aussi tendance à augmenter avec une probabilité plus importante d'avoir des phénomènes d'arcs électriques ou défauts intermittents entraînant des conséquences graves.

Un document US 2 602 841 A divulgue un dispositif de protection de réseaux électriques. Un document EP 2 221 626 A1 divulgue un système de détection par réflectométrie.

D'autres caractéristiques propres aux installations électriques imposent des dispositifs de protection spécifiques. En particulier, un même dispositif n'est pas adapté à deux réseaux alternatifs de fréquences différentes, ou un réseau continu. Un dispositif pour réseau continu n'est pas non plus adapté à un réseau alternatif.

Ainsi, les solutions actuelles ne permettent pas d'utiliser des dispositifs de protection standards adaptés à toutes les applications, ou au moins d'utiliser des dispositifs de structure proche pour toutes ces applications. Sur le plan économique, ce manque de standardisation ne permet pas d'optimiser les coûts de production.

Un but de l'invention est notamment de pallier les inconvénients précités. A cet effet, l'invention a pour objet un dispositif de protection de réseaux électrique selon la revendication 1.

Le dispositif comporte par exemple en outre des moyens pour mesurer une grandeur électrique à l'intérieur du réseau, un ordre d'ouverture étant envoyé à l'interrupteur lorsque la mesure de cette grandeur dépasse un seuil donné, la grandeur électrique pouvant être le courant.

Avantageusement, les moyens de couplage effectuent par exemple un couplage directif en orientant le signal injecté dans la ligne dans une direction donnée.

Dans un mode de mise en œuvre particulier, au moins un système de détection est programmé pour détecter des modifications d'impédances dans une zone de ligne donnée.

Le signal envoyé pour déclencher l'ouverture d'un interrupteur étant un signal codé, ledit signal codé est véhiculé par le signal de sonde injecté par un système de détection.

Le seuil donné de détection est par exemple programmable.

Dans un autre mode de réalisation possible, au moins le bloc d'injection, le bloc de réception et le bloc de commande et de traitement des données sont mutualisées sur plusieurs lignes, un ou plusieurs multiplexeurs étant insérés entre les blocs d'injection et de réception et les moyens de couplage propres à chaque ligne.

Avantageusement, le dispositif peut être apte à délivrer une information de diagnostic de ligne à partir de détections de variation d'impédances ou de variation de vitesse d'un signal injecté par le système de détection par réflectométrie.

Le réseau est par exemple un réseau de télécommunication.

Dans un mode de réalisation avantageux, le système de détection du dispositif met en œuvre une méthode de réflectométrie multi-porteuses, par exemple du type MCTDR.

D'autres caractéristiques et avantages de l'invention apparaîtront à l'aide de la description qui suit faite en regard de dessins annexés qui représentent :

- la figure 1, un mode de réalisation possible d'un dispositif selon l'invention ;
- la figure 2, un exemple d'exploitation d'un seuil de détection d'un signal retour reçu par un réflectomètre utilisé dans un dispositif selon l'invention ;
- la figure 3, un exemple d'utilisation de dispositifs selon l'invention dans un réseau.

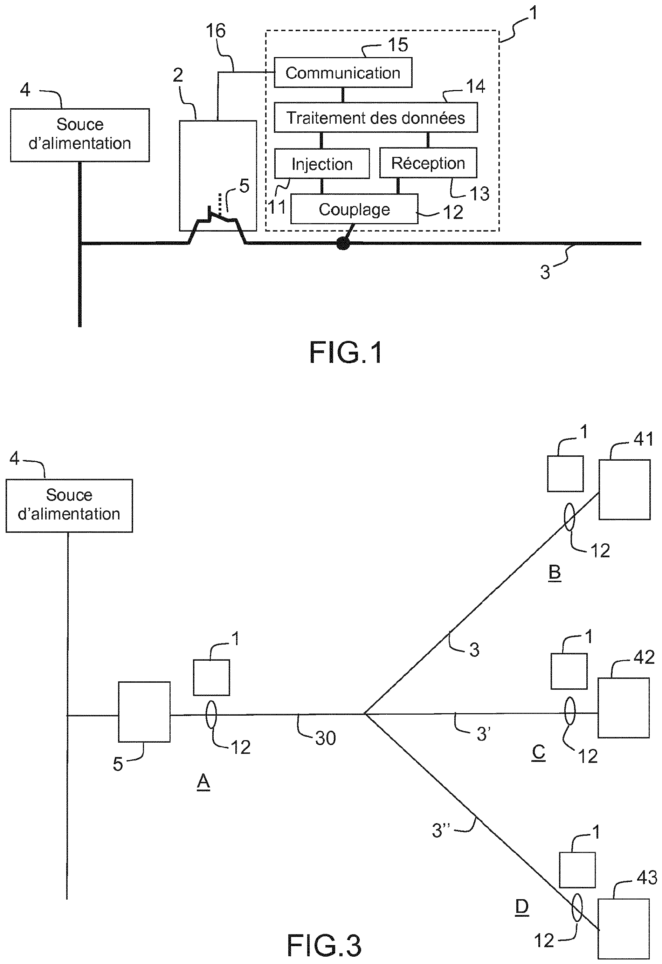

La figure 1 présente par un synoptique un mode de réalisation possible d'un dispositif selon l'invention. Un dispositif selon l'invention comporte au moins deux parties : une première partie 1 destinée à détecter et localiser des défauts sur une ou plusieurs lignes électriques 3 et une deuxième partie 2 composée au moins d'un interrupteur ou contacteur 5 commandable. Cet interrupteur peut être du type électromécanique ou du type électronique, à base de transistors ou de thyristors par exemple. L'interrupteur est relié en entrée à une source d'alimentation électrique 4 et est relié en sortie à un réseau électrique 3. Inversement, l'interrupteur peut-être relié en sortie à une source d'alimentation électrique. Cela permet notamment de prendre en compte le cas des systèmes alimentés par batteries où soit la batterie alimente le moteur, soit le moteur alimente la batterie, alors en charge.

La première partie du dispositif est composée au moins d'un système 1 de détection de défaut fonctionnant selon le principe de la réflectométrie.

Ce principe est proche de celui du radar. Un signal électrique, en général à haute fréquence ou large bande, est injecté en un ou plusieurs endroits d'un réseau de câbles sur lequel un défaut est susceptible d'être détecté. Le signal se propage sur le réseau et renvoie une partie de son énergie lorsqu'il rencontre une discontinuité électrique, c'est-à-dire une modification d'impédance. Dans un cas simple, le signal se propage le long d'une ligne d'alimentation électrique bifilaire, deux conducteurs au moins étant nécessaires à sa propagation. L'invention s'applique pour tous autres types de câbles comprenant un ou plusieurs fils, en particulier pour des câbles trifilaires, des câbles coaxiaux ou des câbles référencés à un plan de masse. Une discontinuité électrique peut résulter d'un défaut. L'analyse des signaux renvoyés au point d'injection permet d'en déduire des informations sur la présence, la nature et la localisation de ces discontinuités, donc des défauts éventuels.

Le système 1 utilisé dans un dispositif selon l'invention comporte donc des blocs permettant de mettre en œuvre ce principe de détection et de localisation par réflectométrie.

Il comporte donc un bloc d'injection 11 et des moyens de couplage 12. Le bloc d'injection comporte notamment un générateur de fréquences délivrant une tension qui forme le signal d'injection encore appelé signal de sonde. Le générateur de fréquences est par exemple programmable.

Le bloc d'injection génère un signal d'injection qui est injecté en un point du réseau 3 par les moyens de couplage 12. A cet effet, les moyens de couplage sont couplés à un point du réseau, ce point étant le point d'entrée du signal d'injection. La ligne électrique sur laquelle est couplé le système étant bifilaire, une connexion est réalisée en un premier point d'un conducteur et l'autre connexion est réalisée en un second point sur l'autre conducteur, en regard du premier point. Dans une application multiconducteurs avec plan de masse, on peut réaliser un couplage par connexion en un point d'un conducteur et l'autre connexion sur le plan de masse. Les moyens de couplage ont notamment pour fonction :

- d'injecter le signal sonde entre deux conducteurs de la ligne sous surveillance ;
- de recevoir le signal de sonde entre deux conducteurs de la ligne sous surveillance ;

Ils peuvent aussi avoir pour fonction :

- de protéger le système de détection du signal natif de la ligne ;
- de protéger le système contre les agressions liées à l'environnement (foudre, etc....) ;
- d'orienter le signal de sonde vers la ligne sous surveillance, cette dernière pouvant faire partie d'un réseau formé par plusieurs lignes, il s'agit alors d'un couplage directif.

Le système de détection par réflectométrie 1 comporte aussi un bloc de réception 13 apte à recevoir les signaux renvoyés par les discontinuités rencontrées par le signal injecté émis. Ces signaux renvoyés sont transmis au bloc de réception via les moyens de couplage 12. Le bloc de réception comporte notamment des filtres adaptés, des amplificateurs faible bruit et des convertisseurs analogique-numérique.

Le système comporte également un bloc intelligent 14. Ce bloc 14 est relié au bloc d'injection 11 et au bloc de réception 13. Il permet notamment de commander le générateur de fréquence programmable du bloc d'injection. Il reçoit les signaux de réception numérisés fournis par le bloc de réception 13. Il effectue notamment le traitement de ces données numériques pour confirmer ou non la présence d'un défaut ainsi que sa localisation. Le système 1 comporte par ailleurs des moyens de communication 15 lui permettant de communiquer avec l'interrupteur 5 ou vers d'autres systèmes, un système de supervision par exemple, notamment dans un mode de réalisation avec plusieurs interrupteurs. Les moyens de communications permettent notamment à l'organe intelligent de commander à distance l'interrupteur 5, directement ou via un système de supervision. En cas de défaut avéré, l'organe de commande peut en effet envoyer un signal de commande à l'interrupteur 5. A réception de ce signal, l'interrupteur ouvre la ligne d'alimentation. A cet effet, l'interrupteur 5 comporte les interfaces nécessaires permettant l'ouverture du circuit à partir d'un signal de commande bas niveau envoyé via les moyens de communication 15. La ligne de communication 16 entre les moyens de communication 15 et l'interrupteur 5 peuvent être sans fil. On peut aussi utiliser comme ligne de communication un câble secondaire. Le système de communication peut également recevoir des informations d'autres organes et ainsi permettre au bloc de traitement 14 de prendre en compte des éléments externes dans la prise de décision. Ceci peut avantageusement être utilisé lorsqu'un composant, un interrupteur par exemple, sur une ligne protégée change d'état. Le bloc de traitement sait alors qu'il s'agit d'un événement normal dans le fonctionnement du système et non pas d'un défaut.

Le système de détection par réflectométrie 1 injecte dans le réseau un signal dont le spectre en fréquence ne perturbe ni les signaux utiles présents sur la ligne, ni l'environnement des câbles du réseau en respectant notamment les gabarits de fréquences relatifs aux contraintes CEM. La période de répétition du signal injecté doit être suffisamment petite pour permettre au système de détecter un premier défaut pouvant potentiellement détruire une installation, ainsi la période de répétition peut être inférieure à 500 $\mu$s, voire plus petite. A cette fin, le signal injecté peut avantageusement être généré selon des méthodes de réflectométrie multi-porteuses, par exemple du type MCTDR (Multi-Carrier Time Domain Reflectometry), ou autres méthodes ayant les mêmes caractéristiques fréquentielles.

Pour des contraintes de bandes passantes des lignes 3 du réseau, les signaux utilisent par exemple des fréquences entre 100 kHz et 200 MHz avec une amplitude inférieure à un volt et une périodicité de l'ordre de la centaine de nanoseconde.

Dans une phase préalable, on effectue le paramétrage du système de détection par réflectométrie en déterminant un seuil de détection. Le seuil de détection correspond à un niveau de tension donné. Un défaut est détecté lorsqu'un signal de réception, issu de la rencontre d'une discontinuité dans le réseau, dépasse ce seuil. Ce seuil peut être variable.

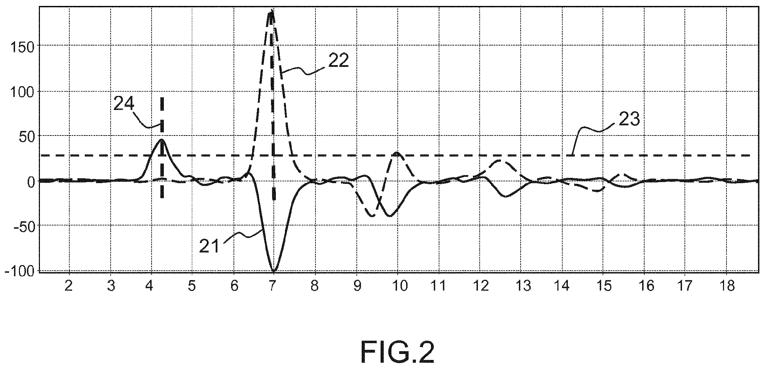

La figure 2 illustre un exemple d'exploitation d'un tel seuil. La figure 2 présente le signal retour d'un signal de sonde du type gaussien donné à titre d'exemple qui est émis dans une ligne électrique et considéré ici comme la signature de référence de cette ligne, ainsi que le signal de retour 22 résultant du calcul de la différence entre la mesure en continu et le signal 21. La référence est enregistrée par le système et placée en mémoire à un instant remarquable dans la vie du système, par exemple :

   ∘ A l'installation ;
   ∘ A la première mise sous-tension ;
   ∘ Au démarrage du système ou sous-système ;
   ∘ sur commande d'un organe externe ;
   ∘ de façon périodique ;
   ∘ ou de façon automatique en prenant en compte la variabilité de l'état des charges ou interconnexions pouvant avoir une conséquence sur la signature de la ligne et qui ne seraient pas des défauts.

La tension V du signal est mesurée en fonction du temps t. On passe du domaine temporel à une distance à partir de la connaissance de la vitesse de propagation qui est paramétrée à l'installation du système ou calculée automatiquement à partir d'une mesure étalon. On définit l'origine 24 comme le point de couplage entre le système de diagnostic filaire et la ligne, c'est aussi la distance zéro, elle peut être déterminée automatiquement par le système ou définie comme paramètre à l'installation.

Dès que les valeurs de l'amplitude de la courbe 22 dépassent un seuil 23 (il est linéaire sur toute la longueur de ligne à titre d'exemple), on considère qu'il y a un défaut sur la ligne. Le temps de propagation du signal aller et retour permet par ailleurs de déterminer la distance parcourue et donc de localiser le défaut. La distance est calculée entre l'origine et la première valeur maximum de l'amplitude après avoir dépassé le seuil. D'autre part, le seuil 23 est défini :

   ∘ en fonction du type de ligne afin de prendre en compte les caractéristiques larges bandes de celle-ci comme l'amortissement et l'atténuation ;
   ∘ en fonction du type de défauts (défaut francs, défauts non-francs) ; en effet en fonction du type de défaut à diagnostiquer, on peut définir plusieurs seuils pour un même système avec plusieurs niveaux d'alarme.

Dès détection d'un défaut, un message est envoyé à l'interrupteur 5 via les moyens de communication 15.
Les défauts que permet de détecter le système de détection par réflectométrie 1, défauts correspondant à des modifications d'impédance dans les lignes électriques, sont notamment les suivants :

-   court-circuit ;

- circuit ouvert ;
- arcs parallèles ;
- arcs séries ;
- défaut d'isolement ;
- décharge partielles.

Tous ces défauts sont susceptibles de causer des dommages dans les installations électriques, en particulier des incendies ou des destructions de matériels électriques. Il est à noter que les systèmes de protection actuels ne détectent pas les circuits ouverts. Un circuit ouvert peut être particulièrement dangereux car il peut être à l'origine d'une électrification accidentelle. Avantageusement, l'invention permet d'obtenir un temps de réaction très court lors de l'apparition d'un défaut électrique. Les constantes de temps en jeu sont en effet très faibles. Elles sont les suivantes :

- la période T d'injection du signal de sonde dans le réseau, T est de l'ordre de la microseconde ;
- le temps aller et retour jusqu'au défaut, quasi nul en regard de la vitesse de propagation du signal électrique et des distances en jeu ;
- le temps de traitement du signal reçu, inférieur à une milliseconde, c'est ce temps qui détermine in fine le temps de réaction global ;
- le temps de transmission du signal reçu, lui aussi négligeable.

La durée Δt entre l'apparition d'un défaut sur le réseau et l'ordre de coupure de l'alimentation électrique à l'interrupteur 5 est donc telle que Δt < 1 ms. Pour détecter des surintensités ou des surtensions, en particulier les surcharges électriques, un capteur de courant ou de tension peut-être couplé au système de détection par réflectométrie 1. Ce capteur peut comporter des moyens de numérisation du courant, la valeur numérisée étant alors transmise au bloc intelligent 14 du système 1.

L'architecture d'un dispositif selon l'invention dépend notamment de la complexité du réseau à sécuriser. La figure 1 présente un exemple simple où le dispositif comporte un système de détection par réflectométrie 1 et un interrupteur 5.

La figure 3 illustre un exemple de réalisation où le dispositif selon l'invention comporte un interrupteur 5, disposé à l'entrée du réseau à sécuriser, et plusieurs systèmes de détection par réflectométrie. Dans cet exemple, le réseau comporte une première ligne bifilaire 30 qui se sépare en trois lignes bifilaires 3, 3', 3", formant trois branches, reliant chacune un équipement électrique 41, 42, 43. Un système de détection par réflectométrie 1 est placé à l'entrée de la première ligne 30. Un système de détection 1 est également couplé à l'extrémité de chaque ligne, au niveau des équipements électriques. En cas de défaut détecté sur une ligne par un des systèmes 1, celui-ci transmet un ordre d'ouverture à l'interrupteur 5. Les systèmes de détection 1 peuvent avantageusement être reliés entre eux par une voie de communications.

Les informations de mesures peuvent alors être envoyées à un système maître qui peut exploiter les mesures des autres systèmes. Cela peut notamment être utile pour localiser précisément un défaut. Dans l'exemple de la figure 3, le système de détection 1 placé en entrée de réseau sur la première ligne 30, peut jouer ce rôle de système maître. Une information de défaut détecté par un autre système avec sa distance à ce système permet notamment de conclure que la ligne concernée est celle couplée au système, le défaut étant à la distance mesurée du système.

Le signal de sonde peut aussi être utilisé pour transmettre les informations, en particulier les informations de défaut et de distance associée, ces informations étant codées sur quelques bits. L'architecture de la figure 3 est un exemple de maillage d'un réseau par des dispositifs selon l'invention. Il est possible de prévoir des maillages plus élaborés notamment pour des réseaux plus importants ou plus complexes. Cependant, l'exemple simple de la figure 3 illustre le principe d'un tel maillage. On peut ainsi prévoir un maillage où chaque segment du réseau est vu par plusieurs systèmes de détection 1, un segment étant une ligne comprise entre deux systèmes de détection. En particulier, on peut réaliser un maillage où chaque segment est vu par n systèmes de détection, le nombre n pouvant varier en fonction des segments. En d'autres termes, un segment d'ordre i est vu par un nombre $n_i$ de systèmes de détection. Dans l'exemple de la figure 3, le réseau comporte trois segments AB, AC, AD où A, B, C, D sont respectivement les emplacements des systèmes de détection sur la première ligne 30, sur la première branche 3, sur la deuxième branche 3' et sur la troisième branche 3". Chaque segment est vu par les deux systèmes de détection 1 disposés à ses extrémités mais aussi par les systèmes de détection des autres segments via le nœud 40 d'où partent les branches. Ainsi le segment AB est vu par tous les systèmes de détection 1 du réseau.

Cela offre notamment la possibilité d'avoir une redondance de l'information de détection et une levée de doute avec au moins deux capteurs indépendants.

Dans l'exemple d'application de la figure 3, le dispositif comporte un interrupteur associé à des systèmes de détection 1 formant le maillage, les systèmes de détection communiquant avec l'interrupteur. Il est possible de placer des dispositifs de protection selon l'invention à la place de chaque système de détection 1, le dispositif comportant un interrupteur. Cela permet éventuellement de réaliser des coupures partielles du réseau. Cela permet aussi d'utiliser des dispositifs standards. On place ainsi en réseau des dispositifs de protection pour former le maillage souhaité. Selon les segments, on utilise ou non l'interrupteur du dispositif.

Plusieurs modes de réalisation d'un dispositif selon l'invention sont possibles. Dans un premier mode de réalisation, la première partie et la deuxième partie peuvent être disposées dans un même boîtier. Plus particulièrement, dans ce cas, l'interrupteur et le système de détection par réflectométrie sont placés dans un même boîtier.

Dans un autre mode de réalisation, les composantes du dispositif selon l'invention sont réparties, comme illustrées par les figures 1 et 3 notamment.

Dans ce dernier cas, le dispositif comporte au moins un interrupteur pour isoler un réseau, ou une partie du réseau de sa source d'alimentation électrique, et au moins un système de détection par réflectométrie communiquant avec le ou les interrupteurs.

Il est également possible de séparer les moyens de couplage 12 des autres composants du système de détection 1. Ce mode de réalisation est notamment adapté pour la protection de lignes sous tension élevée. On place ainsi les moyens de couplage au plus près de la ligne tout en éloignant le reste du système de détection. La liaison entre les moyens de couplage et le système de détection se fait une liaison d'impédance homogène et contrôlée, par exemple une paire de fils torsadés ou un câble coaxial 50Ω. Dans un autre mode de réalisation, le couplage peut être sans fil. Avantageusement, le couplage peut être directif comme indiqué précédemment. Dans ce cas, le dispositif détecte des défauts dans une direction seulement, cette direction étant prédéterminée. Ce mode de couplage est particulièrement adapté lorsque plusieurs lignes à protéger sont reliées à une barre bus, le courant d'alimentation circulant de la barre bus vers des charges via les lignes. La barre bus présentant une faible impédance par rapport aux lignes, le signal de sonde se déplace naturellement vers la barre bus. Le couplage directif permet d'orienter le signal de sonde vers l'aval, c'est-à-dire vers les charges. Le couplage directif peut être réalisé de plusieurs façons. On peut par exemple intercaler une self inductance en amont tout en jouant sur la fréquence du signal de sonde afin d'augmenter l'impédance amont.

Avantageusement, un dispositif selon l'invention permet de détecter, et de répondre rapidement à plusieurs types de défauts, voire même les anticiper. Les mesures issues du réflectomètre, en particulier les modifications d'impédance ou de variation de vitesse de propagation, peuvent être utilisées pour établir un diagnostic de ligne. Ainsi, le bloc de commande et de traitement peut être programmé pour établir un tel diagnostic, en fonction par exemple des paramètres de lignes, de seuils, d'événements ou de signatures prédéfinis caractéristiques d'un état de ligne. Un dispositif selon l'invention peut notamment détecter des défauts intermittents ou « non francs » caractériques par exemple d'un vieillissement ou endommagement local ou global de la ligne ou de la charge, qui peuvent néanmoins endommager les installations ou les matériels.

Un dispositif selon l'invention peut s'appliquer quelle que soit la nature du réseau. En d'autres termes, il est indépendant de la nature du réseau. Il peut s'appliquer quelle que soit la puissance transmise, quelle que soit la fréquence, quelle que soit la tension, que le courant soit continu ou alternatif. En effet, la méthode de réflectométrie appliquée est indépendante de la nature de ces réseaux.

L'invention peut aussi s'appliquer pour protéger des réseaux de télécommunications ou des réseaux d'alimentation où circulent des courants porteurs. Avantageusement, la méthode de réflectométrie ne perturbe pas les transferts de données à l'intérieur du réseau pourvu que l'on choisisse la fréquence adéquate du signal de sonde émis dans le réseau ou d'autres méthodes pour différencier les signaux.

Avantageusement encore, le dispositif selon l'invention peut fonctionner alors que le réseau n'est pas sous-tension, contrairement à des solutions classiques d'analyse en courant et en tension qui exigent que le réseau soit alimenté électriquement. Cela permet notamment de contrôler un réseau avant sa mise sous tension.

Avantageusement, le système de détection par réflectométrie peut émettre des informations sur la localisation d'un défaut électrique. Cette information peut ensuite être exploitée par les services de maintenance.

Avantageusement, un dispositif selon l'invention peut être intégré dans des dispositifs de protection existants. En d'autres termes, il peut compléter des dispositifs classiques en leur adjoignant des systèmes de détection par réflectométrie, ces derniers étant aptes à déclencher l'ouverture des disjoncteurs ou interrupteurs déjà installés. Les informations provenant du capteur à base de réflectométrie peuvent alors être utilisées directement pour déclencher l'ouverture du circuit ou contribuer avec d'autres paramètres à la prise de décision de déclenchement.

Avantageusement, un dispositif selon l'invention peut être paramétré pour protéger une ou plusieurs zones de ligne. On peut aussi paramétrer des paramètres de détection en fonction du type de charge ou de la zone de ligne, en particulier la sensibilité de la détection. A titre d'exemple, pour protéger une charge située à une distance donnée du dispositif, par exemple 10 mètres, on effectue une détection sur la zone située entre 9,5 mètres et 10,5 mètres. Dans ce cas, les moyens de traitement ne traitent que les modifications d'impédances détectées dans la zone à protéger.

Dans une variante de réalisation d'un dispositif selon l'invention, les moyens de communication 15, les moyens de traitement 14 ou bloc de commande et de traitement des données, le bloc d'injection 11 et le bloc de réception 13 peuvent être mutualisés, c'est-à-dire partagés entre plusieurs lignes en insérant entre les blocs d'injection 11 et de réception 13 et les moyens de couplage 12 propres à chaque ligne un ou plusieurs multiplexeurs. En d'autres termes, des moyens de couplage 12 sont affectés à chacune des lignes, les liaisons entre les moyens de couplage et les blocs d'injection et de réception étant assurées par le ou les multiplexeurs.

Chaque ligne est donc protégée par une surveillance effectuée successivement et périodiquement. On peut ainsi prendre une période T1 pour une première ligne, et une période Tn pour la n$^{\text{ième}}$ ligne en faisant en sorte que la durée $t_d$ du plus petit défaut recherché est telle que :

$$T1 + T2 \ldots + Tn < t_d$$

ce qui permet d'être certain de voir le défaut quelle que soit la ligne sur laquelle il se produit.

**Revendications**

1. Dispositif de protection de réseaux électriques, comportant au moins une première partie (1) destinée à détecter un défaut électrique survenant dans un réseau et une deuxième partie (2) comportant au moins un interrupteur (5) reliant ledit réseau à une source d'alimentation électrique (4), la première partie comportant au moins un système de détection par réflectométrie (1), configuré pour détecter le défaut électrique survenant dans un segment de réseau, comportant lui-même un bloc d'injection (11) générant un signal électrique haute fréquence, ledit signal étant injecté dans le segment de réseau via des moyens de couplage (12) et un bloc de réception (13) apte à recevoir un signal en retour du signal injecté dans le réseau, ledit bloc numérisant les signaux reçus; chaque système de détection comporte un bloc de traitement de données (14) et des moyens de communication (15), le bloc de traitement de données (14) étant configuré pour détecter et analyser les modifications d'impédance survenant dans ledit segment de réseau et décider, lorsqu'une modification d'impédance détectée dépasse un seuil donné, de la transmission à la deuxième partie (2) du dispositif, via les moyens de communication (15), d'un signal de commande apte à provoquer le déclenchement de l'ouverture de l'interrupteur (5); ledit dispositif étant **caractérisé en ce que** lesdits moyens de communication (15) étant en outre configurés pour recevoir et transmettre au bloc de traitement (14), des informations de fonctionnement transmises par d'autres bloc de traitement, lesdites informations étant prises en compte par le bloc de traitement (14) pour decider de l'envoi de la commande de déclenchement de l'ouverture de l'interrupteur (5).

2. Dispositif selon la revendication 1, **caractérisé en ce qu'**il comporte en outre des moyens pour mesurer au moins une grandeur électrique à l'intérieur du réseau, un ordre d'ouverture étant envoyé à l'interrupteur (5) lorsque la mesure de cette grandeur dépasse un seuil donné.

3. Dispositif selon la revendication 2, **caractérisé en ce que** la grandeur électrique est le courant.

4. Dispositif selon l'une quelconque des revendications 1 à 3, **caractérisé en ce que** les moyens de couplage (12) effectuent un couplage directif favorisant la propagation, dans une direction donnée, du signal injecté dans la ligne.

5. Dispositif selon l'une quelconque des revendications précédentes, **caractérisé en ce que** le signal envoyé pour déclencher l'ouverture d'un interrupteur (5) est un signal codé, ledit signal codé étant véhiculé par le signal de sonde injecté par ledit au moins un système de détection (1).

6. Dispositif selon l'une quelconque des revendications précédentes, **caractérisé en ce que** le seuil donné de détection est programmable.

7. Dispositif selon l'une quelconque des revendications 1 à 6, **caractérisé en ce qu'**au moins le bloc d'injection (11), le bloc de réception (13) et le bloc de commande et de traitement des données (14) sont partagés entre plusieurs lignes, un ou plusieurs multiplexeurs étant insérés entre les blocs d'injection (11) et de réception (13) et les moyens de couplage (12) propres à chaque ligne.

8. Dispositif selon l'une quelconque des revendications précédentes, **caractérisé en ce que** la première partie (1) comporte un ensemble de systèmes de détection par réflectométrie couplés en plusieurs endroits du réseau électrique considéré pour former un maillage, un segment dudit maillage étant une ligne dudit réseau comprise entre deux systèmes de détection, un segment d'ordre i est vu par un nombre $n_i$ de systèmes de détection, lesdits systèmes étant configurés et agencés pour détecter et analyser les modifications d'impédance survenant dans les différents segments dudit réseau.

9. Dispositif selon la revendication 8, **caractérisé en ce qu'**il comporte la deuxième partie (2) comportant un interrupteur (5) reliant ledit réseau à une source d'alimentation électrique (4), et la première partie comportant une pluralité de systèmes de détection par réflectométrie (1), chacun des systèmes de détection par réflectométrie (1) étant configuré pour détecter et analyser les modifications d'impédance survenant dans un segment de réseau et décider, lorsqu'une modification d'impédance détectée dépasse un seuil donné, de transmettre à la deuxième partie (2) du dispositif, un signal de commande apte à provoquer le déclenchement de l'ouverture de l'interrupteur (5).

10. Dispositif selon l'une quelconque des revendications précédentes, **caractérisé en ce qu'**il est apte à délivrer une information de diagnostic de ligne à partir de détections de variation d'impédance ou de variation de vitesse de propagation d'un signal injecté par le système de détection par réflectométrie (1).

11. Dispositif selon l'une quelconque des revendications précédentes, **caractérisé en ce qu'**un système de détection met en œuvre une méthode de réflectométrie multi-porteuse.

12. Dispositif selon la revendication 11, **caractérisé en ce que** la méthode de réflectométrie multi-porteuse est du type MCTDR.

**Patentansprüche**

1. Vorrichtung zum Schutz von elektrischen Netzen, beinhaltend mindestens einen ersten Abschnitt (1), bestimmt zum Erkennen eines in einem Netz auftretenden elektrischen Fehlers und einen zweiten Abschnitt (2), welcher mindestens einen Schalter (5) beinhaltet, welcher das Netz mit einer elektrischen Speisungsquelle (4) verbindet, wobei der erste Abschnitt mindestens ein Reflektometrie-Detektionssystem (1) beinhaltet, welches dazu konfiguriert ist, den in einem Segment des Netzes auftretenden elektrischen Fehler zu erkennen, seinerseits beinhaltend einen Injektionsblock (11), welcher ein hochfrequentes elektrisches Signal erzeugt, wobei das Signal in das Netzsegment über Kopplungsmittel (12) und einen Empfangsblock (13) injiziert wird, welcher in der Lage ist, ein Antwortsignal des in das Netz injizierten Signals zu empfangen, wobei der Block die empfangenen Signale digitalisiert; wobei jedes Detektionssystem einen Datenverarbeitungsblock (14) und Kommunikationsmittel (15) beinhaltet, wobei der Datenverarbeitungsblock (14) konfiguriert ist, um die in dem Netzsegment eintretenden Impedanzänderungen zu erkennen und zu analysieren und, wenn eine erkannte Impedanzänderung einen gegebenen Schwellenwert überschreitet, über eine Übertragung an den zweiten Abschnitt (2) der Vorrichtung über die Kommunikationsmittel (15) eines Steuersignals, das in der Lage ist, die Auslösung der Öffnung des Schalters (5) hervorzurufen, zu entscheiden; wobei die Vorrichtung **dadurch gekennzeichnet ist, dass** die Kommunikationsmittel (15) zudem konfiguriert sind, um durch andere Verarbeitungsblöcke übertragene Betriebsinformationen zu empfangen und an den Verarbeitungsblock (14) zu übertragen, wobei die Informationen durch den Verarbeitungsblock (14) berücksichtigt werden, um über die Sendung des Auslösebefehls der Öffnung des Schalters (5) zu entscheiden.

2. Vorrichtung nach Anspruch 1, **dadurch gekennzeichnet, dass** sie zudem Mittel zum Messen mindestens einer elektrischen Größe innerhalb des Netzes beinhaltet, wobei ein Öffnungsbefehl an den Schalter (5) gesendet wird, wenn die Messung dieser Größe einen gegebenen Schwellenwert überschreitet.

3. Vorrichtung nach Anspruch 2, **dadurch gekennzeichnet, dass** die elektrische Größe der Strom ist.

4. Vorrichtung nach einem der Ansprüche 1 bis 3, **dadurch gekennzeichnet, dass** die Kopplungsmittel (12) eine gerichtete Kopplung vornehmen, welche die Fortpflanzung des in die Leitung injizierten Signals in eine gegebene Richtung fördern.

5. Vorrichtung nach einem der vorhergehenden Ansprüche, **dadurch gekennzeichnet, dass** das Signal, welches zum Auslösen der Öffnung eines Schalters (5) gesandt wird, ein codiertes Signal ist, wobei das codierte Signal durch das Sondensignal transportiert wird, das von dem mindestens einen Detektionssystem (1) injiziert wird.

6. Vorrichtung nach einem der vorhergehenden Ansprüche, **dadurch gekennzeichnet, dass** der gegebene Erkennungsschwellenwert programmierbar ist.

7. Vorrichtung nach einem der Ansprüche 1 bis 6, **dadurch gekennzeichnet, dass** mindestens der Injektionsblock (11), der Empfangsblock (13) und der Steuerungs- und Datenverarbeitungsblock (14) zwischen mehreren Leitungen geteilt werden, wobei ein oder mehrere Multiplexer zwischen den Injektions- (11) und Empfangsblöcken (13) und den spezifischen Kopplungsmitteln (12) einer jeden Leitung zwischengeschaltet ist/sind.

8. Vorrichtung nach einem der vorhergehenden Ansprüche, **dadurch gekennzeichnet, dass** der erste Abschnitt (1) eine Gruppe von Reflektometrie-Detektionssystemen beinhaltet, welche an mehreren Stellen des betrachteten elektrischen Netzes gekoppelt sind, um ein Raster zu bilden, wobei ein Segment des Rasters eine Leitung des Netzes ist, welche zwischen zwei Detektionssystemen enthalten ist, wobei ein Segment der Ordnung i durch eine Anzahl $n_i$ von Detektionssystemen gesehen wird, wobei die Systeme konfiguriert und angeordnet sind, um die in den unterschiedlichen Segmenten des Netzes eintretenden Impedanzänderungen zu erkennen und zu analysieren.

9. Vorrichtung nach Anspruch 8, **dadurch gekennzeichnet, dass** sie den zweiten Abschnitt (2) beinhaltet, welcher einen Schalter (5) beinhaltet, welcher das Netz mit einer elektrischen Speisungsquelle (4) verbindet, und den ersten Abschnitt, welcher eine Vielzahl von Reflektometrie-Detektionssystemen (1) beinhaltet, wobei jedes der Reflektometrie-Detektionssysteme (1) konfiguriert ist, um die in einem Segment des Netzes eintretenden Impedanzänderungen zu erkennen und zu analysieren, und wenn eine erkannte Impedanzänderung einen gegebenen Schwellenwert überschreitet, über die Übertragung an den zweiten Abschnitt (2) der Vorrichtung eines Steuersignals zu entscheiden, welches in der Lage ist, die Auslösung der Öffnung des Schalters (5) hervorzurufen.

10. Verfahren nach einem der vorhergehenden Ansprüche, **dadurch gekennzeichnet, dass** es in der Lage ist, eine Leitungs-Diagnoseinformation anhand von Erkennungen von Impedanzvariationen oder von Fortpflanzungsgeschwindigkeitsvariationen eines durch das Reflektometrie- Detektionssystem (1) injizierten Signals abzugeben.

11. Vorrichtung nach einem der vorhergehenden Ansprüche, **dadurch gekennzeichnet, dass** ein Detektionssystem ein Vielträger-Reflektometrieverfahren umsetzt.

12. Vorrichtung nach Anspruch 11, **dadurch gekennzeichnet, dass** das Vielträger-Reflektometrieverfahren ein Verfahren vom Typ MCTDR ist.

## Claims

1. A device for protecting electrical networks, comprising at least a first part (1) intended to detect an electrical fault occurring in a network and a second part (2) comprising at least one switch (5) connecting said network to a power supply source (4), the first part comprising at least one reflectometry detection system (1) configured to detect the electrical fault occurring in a network segment, itself comprising an injection unit (11) generating a high-frequency electrical signal, said signal being injected into the network segment via coupling means (12) and a receiving unit (13) capable of receiving a return signal from the signal injected into the network, said unit digitizing the received signals;
each detection system comprising a data processing unit (14) and communication means (15), the data processing unit (14) being configured to detect and analyse impedance changes occurring in the network segment and to decide, when a detected impedance change exceeds a given threshold, on the transmission to the second part (2) of the device, via the communication means (15), of a control signal, capable of triggering the opening of the switch (5); said device being **characterized by**
said communication means (15) further being configured to receive and transmit to the processing unit (14), operation information transmitted by other processing units, said information being taken into account by the processing unit (14) to decide on the sending of the command to trigger the opening of the switch (5).

2. Device according to claim 1, **characterized in that** it further comprises means for measuring at least one electrical variable within the network, an opening command being sent to the switch (5) when the measurement of this variable exceeds a given threshold.

3. The device according to claim 2, **characterized in that** the electrical variable is the current.

4. The device according to any one of claims 1 to 3, **characterized in that** the coupling means (12) perform a directive coupling by enabling the propagation of the signal injected into the line in a given direction.

5. The device according to any one of the preceding claims, **characterized in that** the signal sent to trigger the opening of a switch (5) is a coded signal, said coded signal being carried by the sensor signal injected by the at least one detection system (1).

6. The device according to any one of the preceding claims, **characterized in that** the given detection threshold is programmable.

7. The device according to any one of claims 1 to 6, **characterized in that** at least the injection unit (11), the receiving unit (13) and the control and data processing unit (14) are shared among a plurality of lines, one or more multiplexers being inserted between the injection unit (11) and the receiving unit (13) and the coupling means (12) belonging to each line.

8. The device according to any one of the preceding claims, **characterized in that** the first part (1) comprises a group of reflectometry detection systems coupled at several locations of the considered electrical network in order to form a grid, a segment of said grid being a line of said network contained between two detection systems, a segment of the order of i is being seen by a number $n_i$ of detection systems, said systems being configured and arranged to detect and analyze the impedance changes occurring in the different segments of said network.

9. The device according to claim 8, **characterized in that** it comprises the second part (2) comprising a switch (5) connecting said network to a power supply source (4) and the first part comprising a plurality of reflectometry detection systems (1), each of the reflectometry detection systems (1) being configured to detect and analyze the impedance changes occurring in a network segment and to decide, when a detected impedance change exceeds a given threshold, to transmit to the second part (2) of the device, a control signal, capable of triggering the opening of the switch (5).

10. The device according to any one of the preceding claims, **characterized in that** it is capable of delivering line diagnosis information on the basis of detections of impedance variation or speed variation of a signal injected by the reflectometry detection system (1).

11. The device according to any one of the preceding claims, **characterized in that** a detection system carries out a multi-carrier reflectometry method.

12. The device according to claim 11, **characterized in that** the multi-carrier reflectometry method is of the MCTDR type.

FIG.1

FIG.3

FIG.2

**EP 2 976 819 B1**

## RÉFÉRENCES CITÉES DANS LA DESCRIPTION

### Documents brevets cités dans la description

- US 2602841 A
- EP 2221626 A1